# EUROPEAN PATENT APPLICATION

(11) **EP 3 624 346 A1**
(43) Date of publication of application: **18.03.2020**
(21) Application number: 19159668.3
(22) Date of filing: 27.02.2019
(51) Int. Cl.: H03M 7/30, G01C 21/32, G05D 1/02

(54) **OGM COMPRESSION CIRCUIT, OGM COMPRESSION/DECOMPRESSION SYSTEM, AND MOBILE SYSTEM**

(30) Priority: 13.09.2018 JP 2018171674
(71) Applicant: Kabushiki Kaisha Toshiba, Minato-ku Tokyo 105-0023 (JP); Toshiba Electronic Devices & Storage Corporation, Tokyo, 105-0023 (JP)
(72) Inventor: Uchiyama, Masato, Tokyo 105-8001 (JP)
(74) Representative: Hoffmann Eitle

(57) **Abstract**

According to one embodiment, an acquisition circuit, a modification circuit, and a compressor are included. The modification circuit executes a modification process of modifying first consecutive grids, the number of which is smaller than a preset threshold value in a preset linear scanning direction, among first grids indicating that the obstacle is absent to the second grids. The compressor continuously scans the OGM undergoing the modification process in the scanning direction and encodes the grids in a scanning order.

## Description

### FIELD

Embodiments described herein relate generally to an OGM compression circuit, an OGM compression/decompression system, and a mobile system.

### BACKGROUND

A technology for searching for a route candidate of a moving body such as a vehicle or a robot using an occupancy grid map (OGM) binarized according to the presence or absence of an obstacle which hinders movement of the moving body has been developed. In this instance, it is possible to speed up the search for the route candidate of the moving body by allocating the search for the route candidate of the moving body to a plurality of cores possessed by Many-Core Engine.

However, in a technology of allocating the search for the route candidate of the moving body to the plurality of cores in the Many-Core Engine, all the plurality of cores read the OGM from a memory and search for the route candidate of the moving body, and thus a bus bandwidth of a bus used for reading the OGM from the memory is pressed. The bus bandwidth of the bus used for reading the OGM from the memory by the plurality of cores may be reduced by compressing the OGM saved in the memory. However, when the OGM includes a fine part, it is difficult to increase a compression ratio of the OGM.

An object of one embodiment is to provide an OGM compression circuit, an OGM compression/decompression system, and a mobile system capable of reducing a bus bandwidth of a bus used for reading an OGM from a memory by a core by increasing a compression ratio of the OGM.

### BRIEF DESCRIPTION OF THE DRAWINGS

Fig. 1 is a diagram illustrating an example of a schematic configuration of a moving body to which a mobile system according to a first embodiment is applied;
Fig. 2 is a diagram illustrating an example of a hardware configuration of the moving body to which the mobile system of the first embodiment is applied;
Fig. 3 is a block diagram illustrating an example of a hardware configuration of an information processing device included in the moving body according to the first embodiment;
Fig. 4 is a diagram for description of an example of a modification process in the moving body according to the first embodiment;
Fig. 5 is a flowchart illustrating an example of a flow of a process of saving an OGM used for searching for a route candidate in a memory in the moving body according to the first embodiment;
Fig. 6 is a diagram for description of an example of a compression process of the OGM in the moving body according to the first embodiment; and
Fig. 7 is a diagram for description of an example of a margin assigning process in a moving body according to a second embodiment.

### DETAILED DESCRIPTION

In general, according to one embodiment, an acquisition circuit, a modification circuit, and a compressor are included. The acquisition circuit acquires an OGM containing a grid binarized into first and second grids according to presence or absence of an obstacle. The modification circuit executes a modification process of modifying first consecutive grids, the number of which is smaller than a preset threshold value in a preset linear scanning direction, among first grids indicating that the obstacle is absent to second grids. The compressor continuously scans the OGM undergoing the modification process in the scanning direction and encodes the grids in a scanning order.

Hereinafter, a detailed description will be given of a mobile system to which an OGM compression circuit and an OGM compression/decompression system are applied according to embodiments with reference to accompanying drawings. It should be noted that the invention is not limited by these embodiments.

### (First embodiment)

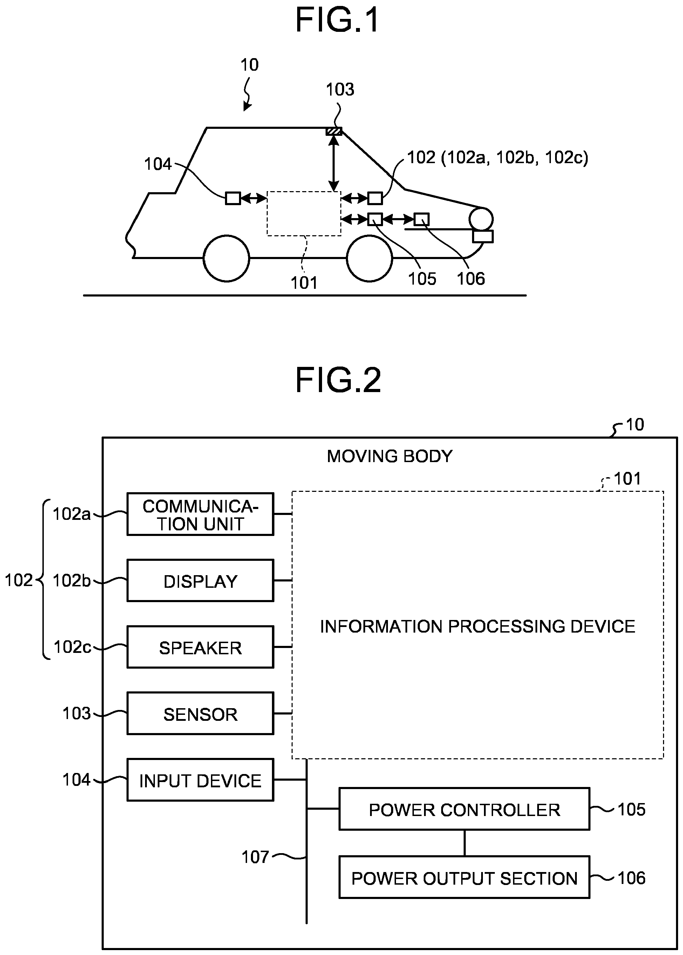

Fig. 1 is a diagram illustrating an example of a schematic configuration of a moving body to which a mobile system according to a first embodiment is applied. Fig. 2 is a diagram illustrating an example of a hardware configuration of the moving body to which the mobile system of the first embodiment is applied. As illustrated in Fig. 1 and Fig. 2, a moving body 10 includes an information processing device 101, an output unit 102, a sensor 103, an input device 104, a power controller 105, and a power output section 106. As illustrated in Fig. 2, the information processing device 101, the output unit 102, the sensor 103, the input device 104, and the power controller 105 are connected via a bus 107. The power output section 106 is connected to the power controller 105.

At least one of the output unit 102 (a communication unit 102a, a display 102b, and a speaker 102c), the sensor 103, the input device 104, and the power controller 105 may be connected to the information processing device 101 by wire or wirelessly. Alternatively, at least one of the output unit 102 (the communication unit 102a, the display 102b, and the speaker 102c), the sensor 103, the input device 104, and the power controller 105 may be connected to the information processing device 101 via a network.

In the present embodiment, a description is given of an example in which the information processing device 101 is mounted in the moving body 10. However, the embodiments are not limited thereto, and the information processing device 101 may be provided in an external device (for example, a stationary object) capable of communicating with the moving body 10. The stationary object corresponds to an object that may not be moved or an object in a stationary state with respect to a ground. For example, the stationary object corresponds to a guardrail, a pole, a parked vehicle, or a road sign. In addition, the information processing device 101 may be mounted in a cloud server that executes processing on a cloud.

The moving body 10 is a movable object. For example, the moving body 10 is a vehicle (a motorcycle, a four-wheeled automobile, or a bicycle), a bogie, a robot, a ship, or a flying object (an airplane or an unmanned aerial vehicle (UAV)). For example, the moving body 10 is a moving body traveling through a driving operation by a person or a moving body capable of automatically traveling (so-called autonomous traveling) without involving a driving operation by a person. Here, for example, the moving body capable of performing autonomous traveling is an automatically driven vehicle. In the present embodiment, a case in which the moving body 10 is an automatically driven vehicle will be described as an example.

The output unit 102 outputs output information such as execution results of various processes executed in the moving body 10. For example, the output unit 102 has a communication function of transmitting output information to the external device, a display function of displaying output information, and a sound output function of outputting sound indicating output information. In the present embodiment, the output unit 102 includes the communication unit 102a, the display 102b, and the speaker 102c.

The communication unit 102a communicates with the external device. The communication unit 102a is a VICS (registered trademark) communication circuit or a dynamic map communication circuit. The communication unit 102a transmits the output information to the external device.

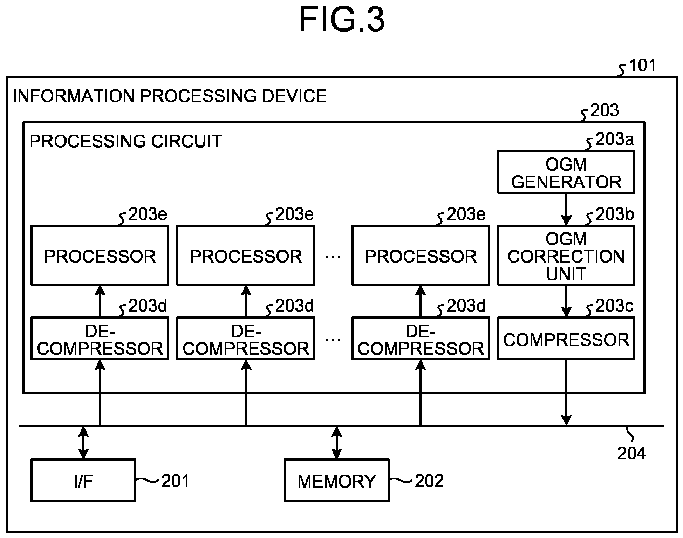

In addition, the communication unit 102a receives road information, etc. from the external device. Here, the road information corresponds to a signal, a sign, a surrounding building, a road width of each lane, a lane center line, etc. The road information may be stored in a memory 202 (see Fig. 3) such as a random access memory (RAM) or a read only memory (ROM) provided in the information processing device 101, or may be stored in a memory other than the memory 202 (see Fig. 2) included in the moving body 10.

The display 102b is a display unit that displays output information. For example, the display 102b is a liquid crystal display (LCD), a projection device, or a light. The speaker 102c outputs sound indicating output information.

The sensor 103 is a sensor that acquires traveling environment of the moving body 10. Here, for example, the traveling environment is observation information of the moving body 10 or surrounding information of the moving body 10. Specifically, the sensor 103 is an external sensor or an internal sensor.

The internal sensor is a sensor that acquires the observation information. For example, the observation information corresponds to acceleration, velocity, or angular velocity of the moving body 10. For example, the internal sensor is an inertial measurement unit (IMU), an acceleration sensor, a velocity sensor, or a rotary encoder. The IMU acquires observation information including triaxial acceleration and triaxial angular velocity of the moving body 10.

The external sensor is a sensor that acquires the surrounding information of the moving body 10. The external sensor may be mounted in the moving body 10 or may be mounted on the outside of the moving body 10 (for example, another moving body or an external device). The surrounding information is information indicating a situation of surroundings of the moving body 10. Here, the surroundings of the moving body 10 corresponds to a region within a range set in advance from the moving body 10, and corresponds to a range in which the surrounding information can be acquired by the external sensor.

For example, the surrounding information is a captured image, distance information, or position information. The captured image corresponds to data of an image obtained by capturing the surroundings of the moving body 10. For example, the captured image corresponds to digital image data defining a pixel value for each pixel, a depth map defining a distance from the sensor 103 for each pixel, etc.

The distance information corresponds to a distance between the moving body 10 and a target present outside the moving body 10. Here, the target present outside the moving body 10 is an object present outside the moving body 10, and is an object present within a range in which the distance information can be acquired by the external sensor. The position information may correspond to a relative position of the moving body 10 with respect to a preset reference position or an absolute position of the moving body 10.

For example, the external sensor corresponds to an image capturing device that captures the surroundings of the moving body 10 to obtain a captured image, a distance sensor (a millimeter wave radar, a laser sensor, or a distance image sensor) that acquires distance information, a position sensor (a global navigation satellite system (GNSS), a global positioning system (GPS), or a radio communication device) that acquires position information, etc. Here, for example, the laser sensor corresponds to a two-dimensional laser imaging detection and ranging (LIDAR) sensor installed parallel to a horizontal plane or a three-dimensional LIDAR sensor.

The input device 104 can input various instructions and various pieces of information from a user. For example, the input device 104 corresponds to a pointing device such as a mouse or a track ball, or an input device such as a keyboard. Further, the input device 104 may correspond to an input function in a touch panel provided integrally with the display 102b.

The information processing device 101 (in the present embodiment, a processor 203e illustrated in Fig. 3) searches for a route on which the moving body 10 moves based on the OGM described below. The power controller 105 controls the power output section 106 based on a search result of the route by the information processing device 101 such that the moving body 10 autonomously travels. Specifically, the power controller 105 determines a situation of the surroundings based on information generated by the information processing device 101, information obtained from the sensor 103, etc. and controls the amount of acceleration, the amount of brake, a steering angle, etc. The power output section 106 is a device driven by control of the power controller 105. For example, the power output section 106 corresponds to an engine, a motor, or a wheel.

Next, a detailed description will be given of an example of a hardware configuration of the information processing device 101 included in the moving body 10 according to the present embodiment. Fig. 3 is a block diagram illustrating the example of the hardware configuration of the information processing device included in the moving body according to the first embodiment.

The information processing device 101 includes an I/F 201, a memory 202, and a processing circuit 203. The I/F 201, the memory 202, and the processing circuit 203 are connected via a bus 204. The I/F 201 is connected to a network (N/W), etc. with another system. In addition, the I/F 201 manages transmission and reception of information to and from the communication unit 102a.

The memory 202 stores various pieces of data. For example, the memory 202 corresponds to a random access memory (RAM), a semiconductor memory element such as a flash memory, a hard disk, an optical disc, etc. The memory 202 may be provided outside the information processing device 101. The ROM holds a program to be executed by the processing circuit 203 or necessary data. The RAM functions as a work area when a program is executed in the processing circuit 203. Further, the memory 202 may be provided outside the moving body 10. Further, the memory 202 may be disposed in a server device installed on the cloud.

In addition, the memory 202 may correspond to a storage medium. Specifically, the storage medium may download a program or various pieces of information via a local area network (LAN), an internet, etc. and store or temporarily store the program or various pieces of information. In addition, the memory 202 may include a plurality of storage media.

The processing circuit 203 includes an OGM generator 203a, an OGM modification unit 203b, a compressor 203c, a plurality of decompressors 203d, and a plurality of processors 203e. Various processing function units (function units of the OGM generator 203a, the OGM modification unit 203b, the compressor 203c, the plurality of decompressors 203d, and the plurality of processors 203e) in processors included in the processing circuit 203 (including the plurality of processors 203e) are stored in the memory 202 in the form of programs executable by a computer. Further, the processors read and execute the programs from the memory 202, thereby realizing the various processing function units corresponding to the respective programs. In the present embodiment, the function units of the OGM generator 203a, the OGM modification unit 203b, the compressor 203c, the decompressor 203d, and the processor 203e are realized by programs. However, the function units may be realized by hardware (circuit).

The processing circuit 203 may be configured by combining a plurality of independent processors for realizing each of the various processing function units in the processors included in the processing circuit 203. In this case, the various processing function units are realized by the respective processors executing the programs. In addition, the various processing function units may be configured as a program, and one processing circuit 203 may executes each program, or an image processing accelerator may be provided as a dedicated circuit, and a specific function may be implemented in an independent program execution circuit.

For example, the term "processor" used in the present embodiment and an embodiment described below means a central processing unit (CPU), a graphical processing unit (GPU), an application specific integrated circuit (ASIC), and a circuit of a programmable logic device (for example, a simple programmable logic device (SPLD), a complex programmable logic device (CPLD), and a field programmable gate array (FPGA)).

The processors included in the processing circuit 203 realize the various processing function units by reading and executing the programs saved in the memory 202. Instead of saving the programs in the memory 202, the programs may be directly incorporated in circuits of the processors. In this case, the processors realize the various processing function units by reading and executing the programs incorporated in the circuits.

The OGM generator 203a functions as an example of an acquisition unit that generates (acquires) an occupancy grid map (OGM). The OGM corresponds to map information including a grid binarized according to the presence or absence of an obstacle that hinders movement of the moving body 10. In the present embodiment, the OGM generator 203a generates the OGM each time a traveling environment of the moving body 10 is acquired by the sensor 103. In the present embodiment, an example of generating the OGM in the moving body 10 is described. However, the embodiments are not limited thereto, and it is possible to acquire an OGM generated in the external device. In addition, in the present embodiment, the OGM generator 203a generates an OGM containing a grid binarized according to the presence or absence of an obstacle that hinders movement of the moving body 10. However, the OGM generator 203a may generate an OGM containing a grid binarized according to whether the moving body 10 is movable. That is, the OGM generator 203a may generate an OGM containing a grid binarized according to not only the presence or absence of an obstacle but also whether the moving body 10 is movable depending on the circumstances around the moving body 10.

The OGM modification unit 203b executes a modification process of modifying consecutive obstacle-free grids, the number of which is smaller than a preset threshold value in a preset scanning direction, among obstacle-free grids contained in the OGM generated by the OGM generator 203a to obstacle-containing grids. In this way, when grids in the OGM are continuously scanned in a preset linear scanning direction, and encoding such as differential encoding is performed in an order of scanning the grids in the OGM, it is possible to increase a compression ratio of the OGM, and to reduce a storage capacity required for storing the OGM in the memory 202.

Here, an obstacle-free grid is a grid (cell) contained in the OGM and is a grid indicating that there is no obstacle (that is, a grid indicating that the moving body 10 is movable). In the present embodiment, the obstacle-free grid indicates 0. In addition, an obstacle-containing grid is a grid (cell) contained in the OGM and is a grid indicating that there is an obstacle (that is, a grid indicating that the moving body 10 is immovable). In the present embodiment, the obstacle-containing grid indicates 1. Here, the obstacle includes not only a physical obstacle but also a case in which the moving body 10 may not be moved due to a legal restriction, etc., that is, a virtual obstacle.

The scanning direction is a direction in which a grid contained in the OGM is scanned when the OGM is compressed by the compressor 203c described below, and is a linear scanning direction. In the present embodiment, the compressor 203c raster-scans the grid contained in the OGM, and thus the scanning direction is a horizontal direction. In the present embodiment, since the compressor 203c performs raster-scanning, the scanning direction is set to the horizontal direction. However, the scanning direction is not limited as long as the scanning direction is a linear scanning direction. For example, it is possible to adopt a vertical direction or an oblique direction.

In addition, the preset threshold value is a lower limit of the number of consecutive obstacle-free grids corresponding to a route of the moving body 10 in the scanning direction. In the present embodiment, the preset threshold value is the number of grids in a width direction of the moving body 10 on the OGM. Here, the preset threshold value is the number of grids larger than the number of grids of noise originally contained in the OGM. In addition, the preset threshold value may be changeable or may be changeable according to a moving speed of a moving body.

In the present embodiment, the modification process is executed on the OGM generated by the OGM generator 203a. However, when an OGM is generated, the OGM may be generated by changing an obstacle-free grid not corresponding to the route of the moving body 10 to an obstacle-containing grid.

Specifically, the OGM generator 203a performs linear scanning in a preset direction with reference to an obstacle-containing grid in the OGM and counts the number of consecutive obstacle-free grids until a subsequent obstacle-containing grid. Then, when the counted number is less than the preset threshold value, the OGM generator 203a changes the scanned obstacle-free grid to an obstacle-containing grid.

For example, the OGM generator 203a performs linear scanning in all directions with reference to an obstacle-containing grid and counts the number of consecutive obstacle-free grids until a subsequent obstacle-containing grid. Then, when the counted number of the consecutive obstacle-free grids is less than the preset threshold value, the OGM generator 203a changes an obstacle-free grid between the reference obstacle-containing grid and the subsequent obstacle-containing grid to an obstacle-containing grid.

In this way, similarly to a case in which a grid in the OGM is modified to an obstacle-containing grid by the OGM modification unit 203b, when grids in the OGM are continuously scanned in a preset linear scanning direction, and encoding such as differential encoding is performed in an order of scanning the grids in the OGM, it is possible to increase a compression ratio of the OGM, and to reduce a storage capacity required for storing the OGM in the memory 202.

The compressor 203c continuously scans grids in the OGM modified by the OGM modification unit 203b in a preset scanning direction, and executes a compression process of performing encoding such as differential encoding in an order of scanning the grids in the OGM. In the present embodiment, the compressor 203c raster-scans the grids in the OGM and performs differential encoding in an order of scanning the grids in the OGM. Then, the compressor 203c saves the OGM undergoing the compression process in the memory 202 via the bus 204.

The decompressor 203d reads the OGM from the memory 202 via the bus 204. Then, the decompressor 203d executes a decompression process on the read OGM. In the present embodiment, the decompressor 203d is provided for each processor 203e, executes the decompression process on the OGM read from the memory 202, and outputs the OGM undergoing the decompression process to the processor 203e.

In the present embodiment, as described above, since the compression ratio of the OGM can be increased, it is possible to decrease a bus bandwidth of the bus 204 required for saving the OGM in the memory 202 and reading the OGM from the memory 202, and to reduce pressure of the bus bandwidth of the bus 204 due to saving of the OGM in the memory 202 and reading of the OGM from the memory 202.

The processor 203e searches for a candidate (hereinafter referred to as a route candidate) for a route on which the moving body 10 moves based on the OGM on which the decompression process has been executed by the decompressor 203d. In the present embodiment, for example, the plurality of processors 203e corresponds to multi-core processors, and searches for a route candidate allocated to each processor 203e in advance with respect to an OGM input from the decompressor 203d. As a result, the plurality of processors 203e can search for the route candidate of the moving body 10 based on the OGM in parallel, and thus it is possible to speed up the search for the route candidate of the moving body 10. Here, it is presumed that the route candidate searched for by the processors 203e is a route candidate on which the moving body 10 can move without contact with an obstacle among route candidates allocated to the respective processors 203e.

In the present embodiment, the route candidate of the moving body 10 is searched for by the plurality of processors 203e. However, the embodiments are not limited thereto, and the route candidate of the moving body 10 may be searched for by one processor 203e. In this case, the processing circuit 203 may not have the plurality of decompressors 203d, and it is sufficient to have one decompressor 203d. In addition, the display 102b may display the route candidate searched for by the processor 203e.

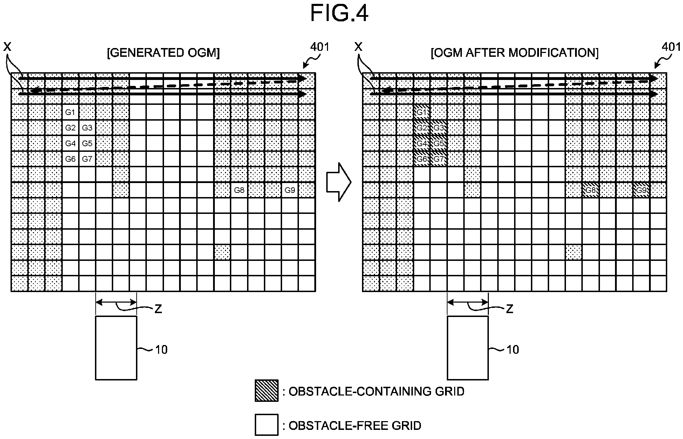

Next, a description will be given of an example of a modification process in which an obstacle-free grid in an OGM is modified to an obstacle-containing grid. Fig. 4 is a diagram for description of an example of the modification process in the moving body according to the first embodiment.

As illustrated in Fig. 4, the OGM modification unit 203b raster-scans grids in an OGM 401 generated by the OGM generator 203a in a scanning direction X (horizontal direction) by the compressor 203c. Then, as illustrated in Fig. 4, the OGM modification unit 203b modifies consecutive obstacle-free grids G1 to G9, the number of which is smaller than a preset threshold value N (the number Z of grids of a vehicle width of the moving body 10 in the OGM 401, for example, 2.5 grids) in a raster-scanning direction, among obstacle-free grids in the OGM 401 to obstacle-containing grids.

In this way, since the number of consecutive obstacle-containing grids can be increased in the OGM 401, when encoding such as differential encoding is performed in an order of scanning the grids in the OGM 401, it is possible to reduce redundancy of data, and to increase a compression ratio of the OGM 401. In addition, it is possible to reduce a storage capacity required for storing the OGM 401 in the memory 202.

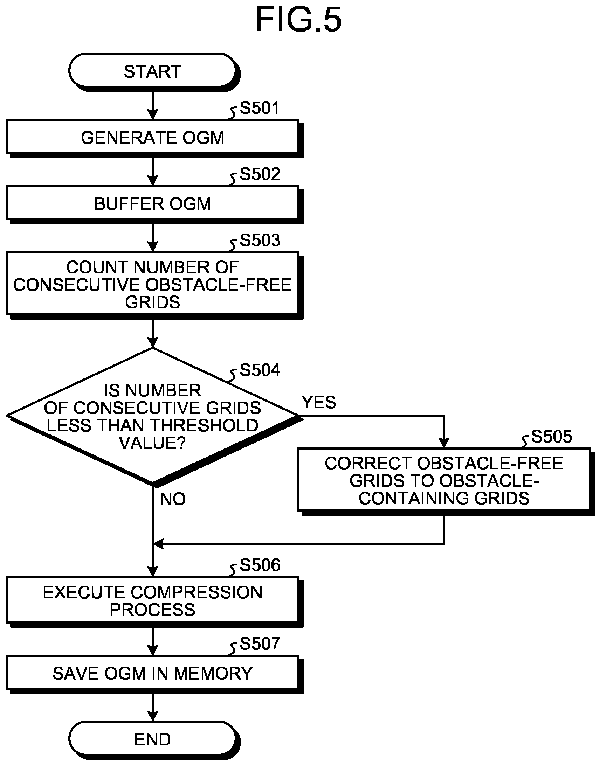

Next, a description will be given of an example of a flow of a process of saving an OGM used for searching for a route candidate of the moving body 10 in the memory 202. Fig. 5 is a flowchart illustrating an example of a flow of a process of saving an OGM used for searching for a route candidate in a memory in the moving body according to the first embodiment.

When an instruction to search for a route candidate of the moving body 10 is input from the input device 104, etc., the OGM generator 203a generates an OGM (Step S501). Then, the OGM generator 203a buffers the generated OGM in a buffer in the processing circuit 203 (Step S502).

For example, the OGM generator 203a saves consecutive grids greater than or equal to a preset threshold value in a buffer according to an order of scanning grids in the generated OGM by the OGM modification unit 203b, and outputs the grids to the OGM modification unit 203b in an order of saving the grids in the buffer.

The OGM modification unit 203b scans grids in the OGM in an order of input from the OGM generator 203a, and counts the number of consecutive obstacle-free grids (Step S503). Subsequently, the OGM modification unit 203b determines whether the number of consecutive obstacle-free grids in the scanning direction in the OGM is less than a preset threshold value (Step S504).

Then, when the counted number is less than the preset threshold value (Step S504: Yes), the OGM modification unit 203b modifies the consecutive obstacle-free grids, the counted number of which is less than the preset threshold value, to obstacle-containing grids (Step S505). On the other hand, when the counted number of consecutive obstacle-free grids is greater than or equal to the preset threshold value (Step S504: No), the OGM modification unit 203b leaves the consecutive obstacle-free grids, the counted number of which is greater than or equal to the preset threshold value, unchanged.

Subsequently, the compressor 203c linearly and continuously scans the grids in the OGM modified by the OGM modification unit 203b in a preset scanning direction to execute a compression process of performing encoding such as differential encoding (Step S506). Thereafter, the compressor 203c saves the OGM undergoing the compression process in the memory 202 (Step S507). In addition, the display 102b may display the OGM modified by the OGM modification unit 203b.

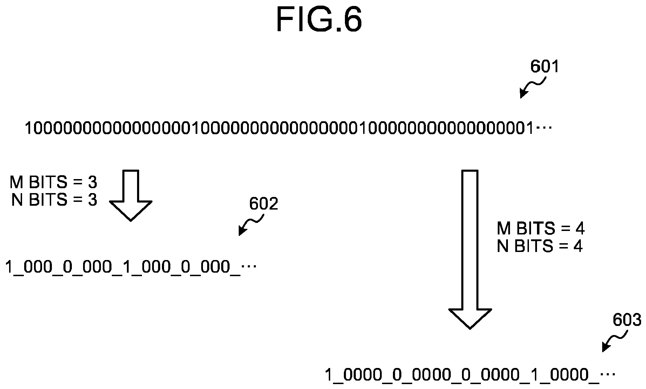

Next, a description will be given of an example of the compression process on the OGM modified by the OGM modification unit 203b. Fig. 6 is a diagram for description of an example of the compression process on the OGM in the moving body according to the first embodiment.

For example, when the number of grids of the vehicle width of the moving body 10 (for example, the vehicle) on the OGM generated by the OGM generator 203a is 16, a pattern of grids in which a compression ratio by a compression process on the OGM by the compressor 203c is lowest corresponds to a loop of a pattern 601 illustrated in Fig. 6. Then, the compressor 203c compresses the OGM into a flag of one bit (hereinafter referred to as a 1-bit flag) indicating whether a certain grid is either an obstacle-free grid or an obstacle-containing grid, and a bit indicating the number of consecutive grids of the same value continuing to the certain grid (hereinafter consecutive number bit).

Here, the consecutive number bit corresponds to a preset number of bits. In the present embodiment, the consecutive number bit corresponds to M bits when the certain grid is an obstacle-free grid and corresponds to N bits when the certain grid is an obstacle-containing grid. In addition, the certain grid is a grid disposed for each number of grids corresponding to an upper limit of the number of consecutive grids which can be represented by the consecutive number bit.

For example, when the M bits corresponds to 3 bits and the N bits corresponds to 3 bits, as illustrated in Fig. 6, the compressor 203c compresses the pattern 601 of 17 bits into a pattern 602 of 8 bits. That is, since data of 4 bits increases each time the certain grid is scanned regardless of whether the certain grid is an obstacle-free grid or an obstacle-containing grid, the compressor 203c can guarantee a compression ratio of 1/2. Here, it is presumed that a grid at an end of the OGM is not compressed.

In addition, for example, when the M bits corresponds to 4 bits and the N bits corresponds to 4 bits, as illustrated in Fig. 6, the compressor 203c compresses the pattern 601 of 17 bits into a pattern 603 of 10 bits. That is, since data of 5 bits increases each time the certain grid is scanned regardless of whether the certain grid is an obstacle-free grid or an obstacle-containing grid, the compressor 203c can guarantee a compression ratio of 10/17.

As described above, according to the first embodiment, the modification process is executed to modify consecutive obstacle-free grids, the number of which is smaller than the preset threshold value in the preset scanning direction, among obstacle-free grids contained in the OGM generated by the OGM generator 203a to obstacle-containing grids. As a result, when grids in the OGM is continuously scanned in a preset linear scanning direction, and encoding such as differential encoding is performed in an order of scanning the grids in the OGM, it is possible to obtain effects that a compression ratio of the OGM can be increased, and a storage capacity required for storing the OGM in the memory 202 can be reduced.

### (Second embodiment)

The present embodiment corresponds to an example of executing a margin assigning process in which an obstacle-free grid adjacent to an obstacle-containing grid in an OGM is filled with an obstacle-containing grid and executing a process in which an obstacle-free grid is modified to an obstacle-containing grid with respect to the OGM undergoing the margin assigning process. In description below, description of the same configuration as that of the first embodiment will be omitted.

In the present embodiment, prior to a modification process of modifying an obstacle-free grid in an OGM to an obstacle-containing grid, the OGM modification unit 203b executes a margin assigning process of filling an obstacle-free grid adjacent to an obstacle-containing grid with an obstacle-containing grid in an OGM generated by the OGM generator 203a.

In this way, at the time of searching for a route candidate of the moving body 10 by the processor 203e based on an OGM, it is possible to search for the route candidate of the moving body 10 by assigning a margin to an existence area of an obstacle. Thus, it is possible to search for a route candidate on which the moving body 10 is less likely to come into contact with the obstacle.

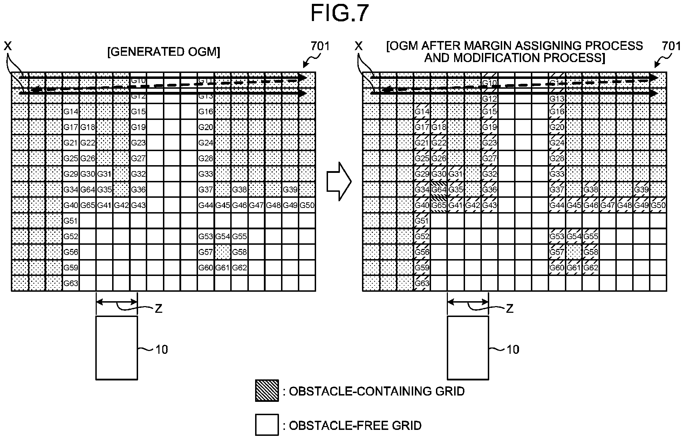

Next, a description will be given of an example of a margin assigning process by the OGM modification unit 203b. Fig. 7 is a diagram for description of an example of a margin assigning process in a moving body according to a second embodiment.

As illustrated in Fig. 7, the OGM modification unit 203b executes a margin assigning process of filling obstacle-free grids G10 to G63 adjacent to an obstacle-containing grid in all directions with obstacle-containing grids with reference to the obstacle-containing grid in an OGM 701 generated by the OGM generator 203a. Thereafter, as illustrated in Fig. 7, similarly to the first embodiment, among obstacle-free grids in the OGM 701 undergoing the margin assigning process, the OGM modification unit 203b modifies consecutive obstacle-free grids G64 and G65, the number of which is smaller than a preset threshold value in a scanning direction of raster-scan, to obstacle-containing grids.

In the present embodiment, the OGM modification unit 203b executes the margin assigning process of filling obstacle-free grids adjacent to an obstacle-containing grid with obstacle-containing grids with reference to the obstacle-containing grid. However, it is possible to execute a margin assigning process of filling consecutive obstacle-free grids within a range of a preset number of grids from an obstacle-containing grid with obstacle-containing grids with reference to the obstacle-containing grid.

Here, the range of the preset number of grids may be arbitrarily set by the user. Alternatively, the range of the preset number of grids may be changed according to a moving speed of the moving body 10. For example, the range of the preset number of grids is increased as the moving speed of the moving body 10 increases.

As described above, according to the second embodiment, prior to the modification process of modifying an obstacle-free grid in an OGM to an obstacle-containing grid, the margin assigning process of filling obstacle-free grids adjacent to an obstacle-containing grid with obstacle-containing grids is executed in the OGM generated by the OGM generator 203a. As a result, at the time of searching for a route candidate of the moving body 10 based on the OGM by the processor 203e, it is possible to search for the route candidate of the moving body 10 by assigning a margin to an existence area of an obstacle. Thus, it is possible to obtain an effect that it is possible to search for a route candidate on which the moving body 10 is less likely to come into contact with the obstacle.

## Claims

1. An occupancy grid map (OGM) compression circuit (101) comprising:
an acquisition circuit (203a) that acquires an OGM containing grids binarized into first and second grids according to presence or absence of an obstacle;
a modification circuit (203b) that executes a modification process of modifying first consecutive grids, the number of which is smaller than a preset threshold value in a preset linear scanning direction, among first grids indicating that the obstacle is absent to the second grids; and
a compressor (203c) that continuously scans the OGM undergoing the modification process in the scanning direction and encodes the grids in a scanning order.

2. The OGM compression circuit (101) according to claim 1, wherein the modification circuit (203b) executes a margin assigning process of filling a first grid adjacent to the second grid in the OGM with the second grid and executes the modification process on the OGM undergoing the margin assigning process.

3. The OGM compression circuit (101) according to claim 1, wherein the compressor (203c) raster-scans the OGM undergoing the modification process.

4. The OGM compression circuit (101) according to claim 1, wherein the modification circuit (203b) executes a margin assigning process of filling the first consecutive grids within a range of a preset number of grids from the second grid in the OGM with the second grids and executes the modification process on the OGM undergoing the margin assigning process.

5. The OGM compression circuit (101) according to claim 4, wherein the range of the preset number of grids is changeable according to a moving speed of a moving body (10) .

6. The OGM compression circuit (101) according to claim 1, wherein the threshold value is changeable.

7. The OGM compression circuit (101) according to claim 1, wherein the threshold value is changeable according to a moving speed of a moving body (10).

8. The OGM compression circuit (101) according to claim 1, wherein the obstacle includes a physical obstacle and a virtual obstacle.

9. An OGM compression circuit (101) comprising:
a generation circuit (203a) that generates an occupancy grid map (OGM) containing grids binarized presence or absence of an obstacle, first consecutive grids, the number of which is smaller than a preset threshold value in a preset linear scanning direction, among first grids indicating that the obstacle is absent being changed to the second grids; and
a compressor (203e) that continuously scans the generated OGM in the scanning direction and encodes the grids in a scanning order.

10. The OGM compression circuit (101) according to claim 9, wherein the compressor (203e) raster-scans the generated OGM.

11. The OGM compression circuit (101) according to claim 9, wherein the generation circuit (203a) generates an OGM obtained by filling a first grid adjacent to the second grid in the first and second grids binarized according to presence or absence of the obstacle with the second grid, and then changing the first consecutive grids, the number of which is smaller than a preset threshold value in a preset linear scanning direction, among the first grids to the second grids.

12. The OGM compression circuit (101) according to claim 9, wherein the generation circuit (203a) generates an OGM obtained by filling the first consecutive grids within a range of a preset number of grids from the second grid in the first and second grids binarized according to presence or absence of the obstacle with the second grids, and then changing the first consecutive grids, the number of which is smaller than the preset threshold value in the preset linear scanning direction, among the first grids to the second grids.

13. The OGM compression circuit (101) according to claim 12, wherein the range of the preset number of grids is changeable according to a moving speed of a moving body (10) .

14. The OGM compression circuit (101) according to claim 9, wherein the threshold value is changeable.

15. The OGM compression circuit (101) according to claim 9, wherein the threshold value is changeable according to a moving speed of a moving body (10).

16. The OGM compression circuit (101) according to claim 9, wherein the obstacle includes a physical obstacle and a virtual obstacle.

17. The OGM compression circuit (101) according to claim 1, further comprising
a memory (202) that stores the encoded OGM.

18. An OGM compression/decompression system (101) comprising:
the OGM compression circuit (101) according to claim 17;
a decompressor (203d) that reads the OGM from the memory (202) and executes a decompression process on the read OGM; and
a processor (203e) that searches for a candidate for a route on which the moving body (10) moves based on the OGM undergoing the decompression process.

19. The OGM compression/decompression system (101) according to claim 18, wherein the processor (203e) corresponds to a multi-core processor to which search for a candidate for a route on which the moving body (10) moves is allocated based on the OGM undergoing the decompression process.

20. A mobile system comprising:
a power output secion (106) of a moving body (10);
the OGM compression/decompression system (101) according to claim 18; and
a power control circuit (105) that controls the power output section (106) based on a result of searching for the candidate for the route by the processor (203e) so that the moving body (10) automatically travels.

21. The mobile system according to claim 20, further comprising:
a display (102b) that displays the OGM undergoing the modification process.
